# EUROPÄISCHE PATENTSCHRIFT

(11) **EP 1 182 664 B1**
(45) Veröffentlichungstag und Bekanntmachung des Hinweises auf die Patenterteilung: **07.04.2004**
(21) Anmeldenummer: 01116965.3
(22) Anmeldetag: 12.07.2001
(51) Int. Cl.: G11C 8/08, G11C 8/00, G11C 29/00

(54) **Schaltungsanordnung zum Deaktivieren von Wortleitungen einer Speichermatrix**
Memory matrix word line de-assertion circuit
Circuit de désactivation de lignes de mot d'une matrice de mémoire

(30) Priorität: 08.08.2000 DE 10038665
(43) Veröffentlichungstag der Anmeldung: 27.02.2002
(73) Patentinhaber: Infineon Technologies AG, 81669 München (DE)
(72) Erfinder: Fischer, Helmut, Dr., 82024 Taufkirchen (DE); Schnabel, Joachim, 81549 München (DE)
(74) Vertreter: Patentanwaltskanzlei WILHELM & BECK

(56) Entgegenhaltungen:
- EP-A- 0 600 160
- US-A- 6 046 956
- US-A- 6 088 286

## Beschreibung

Die Erfindung betrifft eine Schaltungsanordnung zum Deaktivieren von Wortleitungen einer Speichermatrix, gemäß dem Oberbegriff des Patentanspruchs 1.

In den üblichen digitalen Informationsspeichern bilden die Speicherzellen eine Matrix aus Reihen und Spalten. Um eine Speicherzelle zum Einschreiben oder Auslesen anzuwählen, wird eine der betreffenden Reihe zugeordnete "Wortleitung" aktiviert und eine der betreffenden Spalte zugeordnete "Bitleitung" angesteuert. Die selektive Aktivierung der Wortleitungen, also die "Adressierung" der Reihen der Matrix, übernimmt üblicherweise ein Reihen-Adressendecoder, der mit den Wortleitungen individuell verbundene Ausgänge hat und Eingänge zum Empfang der Bits einer digitalen Reihenadresse aufweist. In ähnlicher Weise erfolgt die selektive Ansteuerung der Bitleitungen durch einen Spalten-Adressendecoder.

Die Aktivierung einer Wortleitung geschieht durch Anlegen eines Aktivierungspotentials, welches die Schalttransistoren der zugeordneten Speicherzellen so konditioniert, dass die in den Speicherzellen gespeicherten Ladungen auf die jeweiligen Bitleitungen übertragen werden. Das Aktivierungspotential wird vom Reihen-Adressendecoder angelegt, der die jeweils zu aktivierende Wortleitung auswählt.

Nach erfolgtem Lese- bzw. Schreibbetrieb wird die Wortleitung wieder deaktiviert, indem sie auf ein Deaktivierungspotential gebracht wird, welches die Zellentransistoren sperrt. Das Deaktivierungspotential wird vom Reihen-Adressendecoder durch Leitendmachung einer der betreffenden Wortleitung individuell zugeordneten Anschlusseinrichtung angelegt, welche die betreffende Wortleitung mit einem das diesbezügliche Potential führenden Zuleitungssystem verbindet. Diese Anschlusseinrichtung ist üblicherweise ein Transistorschalter, der in Ansprache auf einen Deaktivierungsbefehl voll durchgeschaltet wird.

Bei manchen Tests, die zur Funktionsprüfung an Speichermatrizen vorgenommen werden, erfolgt eine vorübergehende Aktivierung und anschließende Deaktivierung von Wortleitungen, ohne dass ein Schreib- oder Lesebetrieb während der Aktivierung durchgeführt wird. Diese Test-Aktivierung kann z.B. dem Nachweis einer Gefahr von Leckströmen dienen, insbesondere wenn man hierbei die Aktivierung über längere Dauer aufrecht erhält und/oder mit etwas überhöhtem Aktivierungspotential durchführt. Solche Leckströme können beispielsweise von den aktivierten Wortleitungen zu Speicherzellen benachbarter nicht-aktivierter Wortleitungen fließen. Eventuell auftretende Leckströme beeinflussen mithin den Ladezustand von Speicherzellen an nicht-aktivierten Wortleitungen, was durch nachträgliche Überprüfung deren Speicherinhalte feststellbar ist. Um Testzeit einzusparen, wird die Test-Aktivierung vorzugsweise an mehreren Wortleitungen gleichzeitig durchgeführt, und zwar in derartiger Auswahl, dass den aktivierten Wortleitungen nicht-aktivierte Exemplare benachbart sind. Dieser sogenannte "Multiple-Wordline-Select", der im Reihen-Adressendecoder vorprogrammiert sein kann, sollte beispielsweise bestehen in der Auswahl jeder vierten Wortleitung zur Aktivierung, während die dazwischen liegenden Wortleitungen inaktiv gehalten werden.

Bei der gleichzeitigen Deaktivierung mehrerer aktiver Wortleitungen addieren sich die über die zugeordneten Deaktivierungstransistoren fließenden Entladeströme zu einem relativ hohen Gesamtstrom, der das Netz belastet, welches das Deaktivierungspotential führt. Dieses Netz besteht hierbei hauptsächlich aus den inaktiven Wortleitungen und einer aus Platzgründen relativ schmalen und somit relativ hochohmigen Verdrahtung im Reihen-Adressendecoder, welche das Deaktivierungspotential auch an zugeordnete Anschlüsse andere Elemente des Decoders verteilt. Infolge des hohen Widerstandes der diese verdrahtung bildenden Metallisierung tritt beim gleichzeitigen Deaktivieren der aktiven Wortleitungen ein ohmscher Spannungsabfall am besagten Netz auf, der die anderen, inaktiven Wortleitungen belastet, am stärksten die direkt benachbarten Exemplare. Hier erfolgt eine größere Spannungsanhebung, die proportional der Anzahl der aktiven Wortleitungen und somit proportional der angestrebten Zeitersparnis ist. Die auftretende Spannungsanhebung verursacht in den betroffenen Wortleitungen eine Reduzierung der sperrenden Wirkung der zugeordneten Zellentransistoren, wodurch die Information in angeschlossenen Zellen teilweise oder gänzlich gelöscht werden kann.

Um dieser Gefahr vorzubeugen, hat man bisher die Anzahl der Wortleitungen, die beim Multiple-Wordline-Select jeweils gleichzeitig angewählt werden, gering gehalten. Als Folge ergab sich jedoch eine längere notwendige Testzeit. Eine Alternative wäre, das Netz des Deaktivierungspotentials sehr niederohmig auszulegen, was jedoch breitere Metallisierungen erfordern würde und aus Platzgründen unerwünscht ist.

Aus US6088286 ist es bekannt, das Steuersignal für die Leitendmachung der die Wortleitungen deaktivierenden Transistorschalter stets mit derartiger Amplitude bzw. Flankensteilheit zu erzeugen, dass diese Transistoren nicht abrupt in die volle Sättigung gebracht werden. Eine hiermit einhergehende Reduzierung des Stromflusses verlangsamt den Deaktivierungsvorgang, was bei normalen Schreib- und Lesezyklen eine unnötige Zeitverschwendung bedeutet.

Die Aufgabe der vorliegenden Erfindung besteht in der Bereitstellung technischer Mittel, die sowohl ein schnelle Folge von Lese- bzw. Schreibzyklen an der Speichermatrix gestatten als auch erlauben, eine relativ große Anzahl aktiver Wortleitungen an einer Speichermatrix gleichzeitig und ohne störende Begleiteffekte zu deaktivieren. Diese Aufgabe wird erfindungsgemäß durch eine Schaltungsanordnung mit den im Patentanspruch 1 beschriebenen Merkmalen gelöst. Vorteilhafte Ausgestaltungen der Erfindung sind in den Unteransprüchen gekennzeichnet.

Demnach wird die Erfindung realisiert an einer Schaltungsanordnung zum Deaktivieren von Wortleitungen einer Speichermatrix, deren jeder ein Deaktivierungstransistor zugeordnet ist zum verbinden der betreffenden Wortleitung mit einem gemeinsamen, das Deaktivierungspotential für die Wortleitungen führenden Zuleitungssystem, mit einer Steuerschaltung, die in Ansprache auf einen Deaktivierungsbefehl ein die Deaktivierungstransistoren leitend machendes Deaktivierungs-Steuersignal erzeugt und zwei alternativ einschaltbare Stromzweige aufweist. Der erste Stromzweig verbindet nur in seinem eingeschalteten Zustand die Steuerelektroden der Deaktivierungstransistoren mit einem diese Transistoren sperrenden ersten Potential. Der zweite Stromzweig verbindet nur in seinem eingeschalteten Zustand die Steuerelektroden der Deaktivierungstransistoren mit einem diese Transistoren in Durchlassrichtung vorspannenden zweiten Potential und enthält Mittel, welche die Amplitude und/oder der Flankensteilheit des Deaktivierungs-Steuersignals reduzieren. Erfindungsgemäß sind diese Mittel derart ausgebildet, dass der über das Zuleitungssystem fließende Gesamtstrom einen vorgegebenn Wert nicht überschreitet, und die Steuerschaltung enthält einen dritten Stromzweig, der alternativ zum ersten und zweiten Stromzweig einschaltbar ist und der nur in seinem eingeschalteten Zustand die Steuerelektroden der Deaktivierungstransistoren mit einem diese Transistoren in die Sättigung treibenden dritten Potential verbindet.

Durch Einschalten des zweiten Stromzweiges lassen sich starke Ströme in dem das Deaktivierungspotential führenden Zuleitungssystem und somit die weiter oben erwähnten Spannungserhöhungen, die bei Deaktivierung von mehreren gleichzeitig aktivierten Wortleitungen normalerweise zu befürchtenden sind, reduzieren oder gänzlich vermeiden. Es ist somit möglich, Tests im Multiple-Wordline-Select mit weit mehr Wortleitungen als bisher durchzuführen und somit die Gesamt-Testzeit an einer Speichermatrix zu verkürzen. Durch Einschalten des dritten Stromzweiges läßt sich die für normale Schreib- und Lesezyklen übliche schnelle Wortleitungs-Deaktivierung erreichen.

Die gewünschte Strombegrenzung durch den den zweiten Stromzweig kann erreicht werden, indem man das Verhältnis der effektiven Widerstände von Wortleitungs-Anschlusseinrichtung und Deaktivierungspotential-Zuleitungsystem passend bemisst. Durch eine Vergrößerung des Widerstandes der Anschlusseinrichtungen zwischen Wortleitung und Deaktivierungspotential-Zuleitungssystem wird der Entladestrom der aktiven Wortleitungen besser auf alle inaktiven Wortleitungen verteilt. Dementsprechend enthält eine vorteilhafte Ausführungsform der erfindungsgemäßen Reduziereinrichtung Mittel zur Erhöhung des elektrischen Widerstandes der Anschlusseinrichtungen.

Diese Mittel können darin bestehen, an jeder Anschlusseinrichtung einen Reihenwiderstand vorzusehen, der normalerweise überbrückt ist und nur dann wirksam geschaltet wird, wenn gleichzeitig mehrere aktive Wortleitungen deaktiviert werden sollen. Dies erfordert jedoch eine Vielzahl zusätzlicher Bauelemente und Verdrahtungen. Ein eleganterer Weg lässt sich beschreiten, wenn jede Anschlusseinrichtung wie an sich bekannt aus einem Deaktivierungstransistor besteht, dessen Hauptstromstrecke zwischen der betreffenden Wortleitung und dem Zuleitungssystem liegt und dessen Steuerelektrode das Deaktivierungs-Steuersignal empfängt. In diesem Fall kann die Vergrößerung des elektrischen Widerstandes der Anschlusseinrichtung erzielt werden durch eine Verringerung des Spannungshubes für das Deaktivierungs-Steuersignal, also durch Verminderung der den besagten Transistor aufsteuernden Amplitude dieses Signals. Zusätzlich oder alternativ kann die erfindungsgemäße Reduziereinrichtung Mittel enthalten zur Verlängerung der Anstiegszeit des Deaktivierungs-Steuersignals. Hierdurch wird ebenfalls eine Strombegrenzung erreicht, weil hohe Entladestromspitzen vermieden werden, wie sie ansonsten bei großer Flankensteilheit des Deaktivierungs-Steuersignals entstehen.

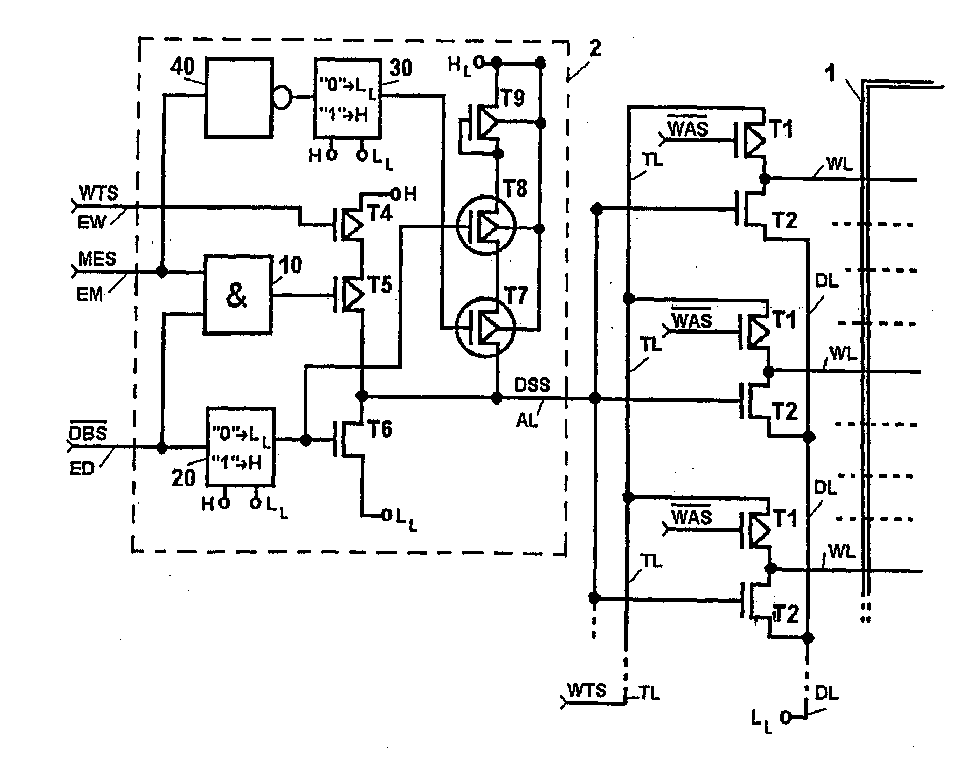

Die Erfindung und Merkmale besonderer Ausgestaltungen derselben werden nachstehend anhand der beigefügten Zeichnung näher erläutert, die das Schaltbild einer bevorzugten Ausführungsform zeigt.

Die Zeichnung zeigt rechts einen Teil des Randes einer Speichermatrix 1, in den die einzelnen Wortleitungen WL münden. Üblicherweise sind die Wortleitungen in verschachtelten Gruppen organisiert, wobei die Wortleitungen verschiedener Gruppen in Spaltenrichtung gesehen zyklisch aufeinanderfolgen. Im hier beschriebenen Fall sind es vier Gruppen, und näher dargestellt sind nur die ersten drei Wortleitungen WL einer ersten Gruppe, welche die erste, die fünfte und die neunte Wortleitung in der Gesamtreihenfolge bilden. Die dazwischen liegenden Wortleitungen der anderen drei Gruppen sind lediglich gestrichelt angedeutet.

Die Speichermatrix 1 bildet eines von mehreren Segmenten eines Speichermoduls. Die Segmente selbst und die Wortleitungen WL innerhalb jedes Segmente sind selektiv von einem Reihen-Adressendecoder ansteuerbar, der unter anderem die dargestellte Schaltung enthält. In diesem Decoder sind auch Quellen bzw. Zuleitungen zur Bereitstellung festgelegter und eindeutig unterscheidbarer elektrischer Potentiale vorgesehen. Hierzu gehören die Potentiale, welche die Pegel "niedrig" (L-Pegel, z.B. 0 Volt) und "hoch" (H-Pegel, z.B. +2,0 Volt) zur Definition der Binär- oder Logikwerte "0" und "1" darstellen, sowie weitere Potentiale, die unten noch näher benannt werden. Es sei angenommen, dass der H-Pegel einer logischen "1" entspricht und positiv gegenüber dem L-Pegel ist, welcher einer logischen "0" entspricht.

Jede Wortleitung WL kann über jeweils einen ersten Wortleitungs-Transistor T1, im folgenden als Aktivierungstransistor bezeichnet, auf ein Aktivierungspotential getrieben werden. Dieses Potential sei im hier beschriebenen Fall der H-Pegel, der die an die Wortleitung angeschlossenen (nicht gezeigten) Zellentransistoren der Speichermatrix 1 so konditioniert, dass sie die in den Speicherzellen gespeicherten Ladungen auf die jeweiligen Bitleitungen übertragen. Jeder der Aktivierungstransistoren T1 ist ein Feldeffekttransistor mit P-Kanal (P-FET), vorzugsweise in MOS-Struktur, über dessen Kanal die betreffende Wortleitung auf H-Pegel gelegt wird, wenn seine Gate-Elektrode ein Wortleitungs-Auswahlsignal WAS mit L-Pegel vom Adressendecoder empfängt. Der H-Pegel wird den Kanälen aller zur jeweils selben Gruppe von Wortleitungen gehörenden Aktivierungstransistoren T1 über eine gemeinsame Treiberleitung TL zugeführt, als Binärzustand eines Wortleitungs-Treibersignals WTS, das vom Adressendecoder auf H-Pegel gebracht wird, wenn eine Wortleitungs-Aktivierung an betreffenden Gruppe erfolgen soll.

Des weiteren ist jede Wortleitung WL über einen zweiten Wortleitungs-Transistor T2, im folgenden als Deaktivierungstransistor bezeichnet, an eine Zuleitung DL angeschlossen, die mit einer Quelle eines Deaktivierungspotentials L_{L} verbunden ist. Dieses Potential ist vorzugsweise ein Pegel, der noch "niedriger" (negativer) als der L-Pegel ist (z.B. -0,3 Volt), um die an die Wortleitung angeschlossenen Zellentransistoren der Speichermatrix 1 mit Sicherheit zu sperren. Der Deaktivierungstransistor T2 ist ein Feldeffekttransistor mit N-Kanal (N-FET), vorzugsweise in MOS-Struktur.

Zur Aktivierung von Wortleitungen WL einer Gruppe bringt der Adressendecoder das Wortleitungs-Treibersignal WTS auf H-Pegel und steuert das Wortleitungs-Auswahlsignal WAS für die zu aktivierenden Exemplare der Wortleitungen auf L-Pegel. Somit schalten die zugeordneten Aktivierungstransistoren T1 durch, und die betreffenden Wortleitungen werden auf H-Pegel getrieben. Vor der Aktivierung und nach Beendigung der Aktivierung wird das Signal WTS auf L-Pegel gehalten. Die hierzu verwendete Steuerschaltung ist in der Zeichnung nicht dargestellt.

Näher dargestellt ist nur die zur Deaktivierung von Wortleitungen WL der ersten Gruppe verwendete Steuerschaltung, in der Zeichnung insgesamt mit der Bezugszahl 2 bezeichnet. Für jede der anderen drei Wortleitungs-Gruppen ist ebenfalls eine solche Steuerschaltung vorgesehen. Die Steuerschaltung 2 hat eine Ausgangsleitung AL, die an die Gate-Elektroden aller Deaktivierungstransistoren T2 angeschlossen ist, um ein Deaktivierungs-Steuersignal DSS zur Aufsteuerung dieser Transistoren zu liefern. Eine erste Eingangsleitung EW ist zum Empfang des Wortleitungs-Treibersignals WTS angeschlossen, eine zweite Eingangsleitung EM ist zum Empfang eines Modus-Einstellsignals MES angeschlossen, und eine dritte Eingangsleitung ED ist zum Empfang eines Deaktivierungs-Befehlssignals DBS angeschlossen.

Mit der Ausgangsleitung AL sind drei verschiedene Steuerstromzweige verbunden. Der erste Zweig führt über den Kanal eines N-FET T6 zum L_{L}-Potential. Der zweite Zweig enthält in Reihenschaltung die Kanäle zweier P-FETs T7 und T8 und einen als Diode verschalteten P-FET T9 und führt zur Quelle eines Potentials H_{L}, das etwas negativer als der H-Pegel, jedoch positiver als der L-Pegel ist. Der dritte Zweig enthält zwei P-FETs T4 und T5, deren Kanäle in Reihe zwischen die Ausgangsleitung AL und eine Potentialquelle für H-Pegel geschaltet sind. Die FETs T4 und T5 sind Schalttransistoren, die im leitenden Zustand keinen nennenswerten elektrischen widerstand haben.

Die Gate-Elektrode des P-FET T4 ist mit der Eingangsleitung EW verbunden. Die Gate-Elektrode des P-FET T5 ist mit dem Ausgang eines ODER-Gliedes 10 verbunden, das zwei Eingänge hat, deren erster an die Eingangsleitung EM und deren zweiter an die Eingangsleitung ED angeschlossen ist. Die Gate-Elektroden des N-FET T6 und des P-FET T8 sind mit dem Ausgang eines Pegelwandlers 20 verbunden, dessen Signaleingang an die Eingangsleitung ED angeschlossen ist. Die Gate-Elektrode des P-FET T7 ist mit dem Ausgang eines Pegelwandlers 30 verbunden, dessen Signaleingang über einen Inverter 40 an die Eingangsleitung EM angeschlossen ist. Die Pegelwandler 20 und 30 sind einander gleich und in an sich bekannter Weise aufgebaut, um an ihrem Ausgang H-Pegel zu liefern, wenn ihr Signaleingang den Binärwert "1" hat, und L_{L}-Pegel zu liefern, wenn ihr Signaleingang den Binärwert "0" hat.

Die Steuerschaltung 2 ist umschaltbar zwischen zwei Betriebsarten, die im folgenden als "Normalmodus" und "Testmodus" bezeichnet werden. Zur Umschaltung dient das Modus-Einstellsignal MES, das für den Normalmodus auf "0" (L-Pegel) und für den Testmodus aus "1" (H-Pegel) gesetzt wird. Die beiden Moden werden nachstehend beschrieben.

### Normalmodus

Im Normalmodus arbeitet die Steuerschaltung 2 in der üblichen Weise, um beim Empfang eines Wortleitungs-Deaktivierungsbefehls an der Eingangsleitung ED die Ausgangsleitung AL sprunghaft auf H-Pegel zu bringen und dadurch die Deaktivierungstransistoren T2 mit steiler Anstiegsflanke in die Sättigung zu treiben, so dass letztere die angeschlossenen Wortleitungen WL möglichst schnell über die Zuleitung DL auf den L_{L}-Pegel entladen.

Dieser Normalmodus wird eingestellt, wenn im Betrieb-der Speichermatrix nur jeweils eine einzige Wortleitung WL durch L-Pegel des zugeordneten Wortleitungs-Auswahlsignals WAS aktiviert worden ist und deaktiviert werden soll. Hierzu wird das Modus-Einstellsignal MES auf "0" gehalten. Bei Beendigung der Wortleitungs-Aktivierung wird das an der Eingangsleitung EW empfangene Signal WTS wie gesagt auf L-Pegel geschaltet. Hierdurch wird der P-FET T4 auf Durchlass konditioniert.

Beim Fehlen eines Deaktivierungsbefehls ist das Signal DBS am Befehlseingang ED auf "1", so dass der Pegelwandler 20 den H-Pegel auf die Gate-Elektrode des N-FET T6 koppelt. Der N-FET T6 ist somit leitend und hält die Ausgangsleitung AL auf L_{L}-Pegel, so dass die Wortleitungs-Deaktivierungstransistoren T2 gesperrt gehalten werden. Der P-FET T5 bleibt vorerst noch nichtleitend, weil seine Gate-Elektrode H-Pegel ("1") vom Ausgang eines ODER-Gliedes 10 erhält, da dieses an einem seiner beiden Eingänge die "1" vom Befehlseingang ED empfängt. Der P-FET T7 wird durch das Ausgangssignal des Pegelwandlers 30 gesperrt, welches auf H-Pegel ist, weil am Eingang dieses Pegelwandlers eine "1" erscheint (invertierte "0" des Modus-Einstellsignals). Der P-FET T8 wird durch den H-Pegel vom Ausgang des Pegelwandlers 20 gesperrt.

Der Deaktivierungsbefehl wird angelegt durch Wechsel des Signals DBS "1" auf "0" (das Signal DBS ist im hier beschriebenen Fall ein "niedrig-aktives" Signal, wie es durch Überstreichung der Buchstabengruppe DBS in der Zeichnung angedeutet ist). Der Pegelwandler 20 wandelt die am Eingang ED erscheinende "0" in L_{L}-Pegel, so dass der N-FET T6 sperrt, wodurch das L_{L}-Potential von der Ausgangsleitung AL abgetrennt wird. Ferner geht der Ausgang des ODER-Gliedes 10, welches die Signale MES und DBS empfängt, auf L-Pegel ("0"), weil seine beiden Eingänge nun auf "0" sind. Dies bewirkt, dass auch der P-FET T5 durchschaltet und somit eine niederohmige Verbindung zwischen der Ausgangsleitung AL und dem H-Potential hergestellt wird. Diese Niederohmigkeit führt dazu, dass das Potential der Ausgangsleitung AL sprunghaft-sofort auf vollen H-Pegel ansteigt.

Es entsteht somit, als Antwort auf den Deaktivierungsbefehl DBS, auf der Leitung AL ein Deaktivierungs-Steuersignal DSS mit steiler Flanke, welches die Wortleitungs-Deaktivierungstransistoren T2 in der gewünschten Weise schnell und voll in die Sättigung durchschaltet, um die aktivierte Wortleitung WL möglichst schnell auf L_{L}-Potential zu entladen.

### Testmodus

Dieser Modus wird eingestellt, wenn für einen Test der Speichermatrix der Multiple-Wordline-Select benutzt wird, bei welchem jeweils mehrere Wortleitungen WL durch L-Pegel des Signals WAS an mehreren Transistoren T1 aktiviert worden sind und gemeinsam deaktiviert werden sollen. Hierzu wird das Modus-Einstellsignal MES auf "1" gesetzt. Bei Beendigung der Wortleitungs-Aktivierung wird das an der Eingangsleitung EW empfangene Signal WTS wie gesagt auf L-Pegel geschaltet. Hierdurch wird der P-FET T4 auf Durchlass konditioniert.

Vor dem Erscheinen des Deaktivierungsbefehls ist das Signal DBS am Befehlseingang ED noch auf "1", so dass der Pegelwandler 20 den H-Pegel auf die Gate-Elektrode des N-FET T6 koppelt. Der N-FET T6 ist somit leitend und hält die Ausgangsleitung AL noch auf L_{L}-Pegel, so dass die Wortleitungs-Deaktivierungstransistoren T2 noch gesperrt gehalten werden. Der P-FET T5 bleibt im Testmodus der Steuerschaltung dauernd nichtleitend, weil seine Gate-Elektrode H-Pegel ("1") vom Ausgang eines ODER-Gliedes 10 erhält, da dieses während des Testmodus an einem seiner beiden Eingänge die "1" vom der Eingangsleitüng MES empfängt. Der P-FET T7 wird während der Dauer des Testmodus durch das Ausgangssignal des Pegelwandlers 30 durchgeschaltet, welches nun auf L_{L}-Pegel ist, weil am Eingang dieses Pegelwandlers eine "0" erscheint (invertierte "1" des Modus-Einstellsignals). Der P-FET T8 bleibt durch den H-Pegel vom Ausgang des Pegelwandlers 20 vorerst noch gesperrt.

Wenn nun der Deaktivierungsbefehl angelegt wird, durch Wechsel des Signals DBS von "1" auf "0", wandelt der Pegelwandler 20 diese "0" in L_{L}-Pegel an seinem Ausgang, so dass der N-FET T6 sperrt, wodurch das L_{L}-Potential von der Ausgangsleitung AL abgetrennt wird. Das L_{L}-Potential vom Ausgang des Pegelverstärkers 20 schaltet nun den P-FET T8 durch, so dass über diesen Transistor T8, den ebenfalls leitenden P-FET T7 und die "Diode" T9 eine leitende Verbindung zwischen der Ausgangsleitung AL und dem H_{L}-Potential hergestellt wird. Hierdurch werden die an die Ausgangsleitung AL angeschlossenen Wortleitungs-Deaktivierungstransistoren T2 in leitenden Zustand versetzt, um die zugeordneten Wortleitungen WL auf das Deaktivierungspotential L_{L} zu entladen.

Die Elemente T7, T8, T9 und das Potential H_{L} sind so dimensioniert, dass das als Antwort auf den Deaktivierungsbefehl entstehende Deaktivierungs-Steuersignal DSS auf der Leitung AL eine andere Charakteristik hat als im zuvor beschriebenen Normalmodus, um die Entladeströme in den aufgesteuerten Deaktivierungstransistoren T2 zu begrenzen. Eine Strombegrenzung ergibt sich, wenn die Endamplitude des Signals DSS unterhalb des Pegels gehalten wird, der zur vollen Durchschaltung der Deaktivierungstransistoren 2 führt. Dies wird erreicht durch Verwendung des Potentials H_{L}, das weniger positiv als der H-Pegel ist (z.B. +1,6 Volt), und durch den als Diode verschalteten P-FET T9, an welchem ein zusätzlicher konstanter Spannungsabfall in Höhe der Schwellenspannung Vₜₕ des P-FET 9 auftritt (z.B. etwa 0,6 Volt). Somit wird das Deaktivierungs-Steuersignal DSS auf einen Pegel H_{L}-Vₜₕ angehoben, der deutlich niedriger bleibt als der im Normalbetrieb über die Transistoren T4 und T5 erreichte H-Pegel. Die Deaktivierungstransistoren 2 erreichen also nicht ihre volle Leitfähigkeit und treiben demzufolge geringeren Strom als im Normalmodus. Auch die inaktiv gebliebenen Exemplare der Wortleitungen sind somit hochohmig an das L_{L}-Zuleitungssystem DL angeschlossen. Das Verhältnis der effektiven Kanalwiderstände der Deaktivierungstransistoren T2 zum Widerstand des Zuleitungssystem DL ist auf diese Weise erhöht, so dass an den inaktiven Wortleitungen keine schädlichen Spannungserhöhungen infolge der Entladeströme aus den aktiven Wortleitungen entstehen.

Eine Strombegrenzung kann auch durch Verminderung der Flankensteilheit des Deaktivierungs-Steuersignals DSS erreicht werden. Bei steiler Anstiegsflanke dieses Signals haben die über die Deaktivierungstransistoren T2 fließenden Entladeströme aus den aktiven Wortleitungen WL zu Beginn der Entladung eine hohe Spitze, die viel beiträgt zu den unerwünschten Spannungserhöhungen an den inaktiven Wortleitungen. In einer besonderen Ausführungsform der Erfindung ist daher eine Maßnahme zur Reduzierung der besagten Flankensteilheit getroffen.

In der dargestellten Steuerschaltung 2 besteht diese Maßnahme darin, den Schaltungszweig, der die Reihenschaltung der FETs T7 und T8 enthält, so auszubilden, dass er im eingeschalteten Zustand einen merklichen Durchlasswiderstand hat (höher als der Durchlasswiderstand der P-FETs T4 und T5). Je höher dieser Widerstand ist, desto flacher ist die Anstiegsflanke des Deaktivierungs-Steuersignals DSS, wegen der vergrößerten RC-Zeitkonstante mit den Gate-Masse-Kapazitäten der Deaktivierungstransistoren T2. Der merkliche Durchlasswiderstand wird vorzugsweise geschaffen durch eine relativ kleine Dimensionierung der P-FETs T7 und T8 (im Vergleich zur Dimensionierung der P-FETs T4 und T5).

In der Zeichnung sind die P-FETs T7 und T8 als Transistoren mit reduzierter Schwellenspannung dargestellt. Die Verwendung solcher Elemente kann vorteilhaft im Sinne der angestrebten Eigenschaften des betreffenden Stromkreises sein. Es können aber auch Transistoren ohne reduzierte Schwellenspannung verwendet werden. Im gleichen Sinne kann es vorteilhaft-sein, die die Substratanschlüsse der Transistoren T7, T8, T9 an das Potential H_{L} zu legen, wie dargestellt.

Die Erfindung ist nicht beschränkt auf die vorstehend beschriebene und in der Zeichnung dargestellte Steuerschaltung 2, die nur ein Ausführungsbeispiel zur Realisierung des Erfindungsgedankens ist. Es sind verschiedene Abwandlungen der beschriebenen Schaltungsanordnung oder alternative Ausführungsformen möglich.

So kann der als Diode verschaltete P-FET T9 auch durch eine echte Diode ersetzt werden; er kann auch ersatzlos weggelassen werden, wenn das Potential H_{L} allein schon niedrig genug ist, um die angestrebte Reduzierung der Endamplitude des Signals DSS zu erreichen. Auch kann man statt des Potentials H_{L} den vollen H-Pegel an das Ende des betreffenden Stromzweiges legen, wenn die Schwellenspannung des als Diode verschalteten P-FET T9 (oder einer dort befindlichen Diode) allein für die Pegelreduzierung genügt; gewünschtenfalls können mehrere als Diode verschaltete Transistoren (oder mehrere Dioden) in Reihe geschaltet werden. Der spürbare Widerstand des besagten Stromzweiges zur Reduzierung der Flankensteilheit des Signals DSS kann auch durch Einfügung eines zusätzlichen ohmschen Elementes erreicht werden, oder dadurch, dass zumindest einer der Transistoren T7 und T8 nur begrenzt aufgesteuert wird, etwa durch Reduzierung des vom Pegelwandler 30 gelieferten Einschaltpegels. Auch kann es genügen, entweder nur die Endamplitude oder nur die Flankensteilheit des Deaktivierungs-Steuersignals DSS zu reduzieren.

Vorgabe ist allgemein, bei Deaktivierung mehrerer aktiver Wortleitungen die aus den einzelnen Wortleitungen fließenden Einzelströme jeweils so weit zu begrenzen, dass die Summe dieser Ströme unter einem kritischen Wert bleibt. Das Maß der einzurichtenden Strombegrenzung hängt davon ab, wie viele aktive Wortleitungen man gleichzeitig zu deaktivieren wünscht und wie hoch der kritische Wert ist. Letzterer ist hauptsächlich bestimmt durch die konstruktionsbedingte Impedanz des Zuleitungssystems für das Deaktivierungspotential. Diese Vorgaben bilden die Randbedingungen für die Einstellung der Strombegrenzung und somit für die Dimensionierung der Bauelemente und Pegel, die in der erfindungsgemäßen Reduziereinrichtung zur Strombegrenzung herangezogen werden.

### Bezugszeichenliste

- 1: Speichermatrix
- 2: Steuerschaltung
- 10: ODER-Glied
- 20: Pegelwandler
- 30: Pegelwandler
- 40: Inverter

- T1: Aktivierungstransistor
- T2: Deaktivierungstransistor
- T4: Steuerzweigtransistor
- T5: Steuerzweigtransistor
- T6: Steuerzweigtransistor
- T7: Steuerzweigtransistor
- T8: Steuerzweigtransistor
- T9: als Diode verschalteter Transistor

- AL: Ausgangsleitung
- DL: Deaktivierungspotential-Zuleitung
- ED: Befehls-Eingangsleitung
- EM: Modus-Eingangsleitung
- EW: Eingang f. Wortleitungs-Treibersignal
- TL: Treibersignalleitung

## Patentansprüche

1. Schaltungsanordnung zum Deaktivieren von Wortleitungen (WL) einer Speichermatrix (1), deren jeder ein Deaktivierungstransistor (T2) zugeordnet ist zum Verbinden der betreffenden Wortleitung mit einem gemeinsamen, das Deaktivierungspotential für die Wortleitungen führenden Zuleitungssystem (DL),
mit einer Steuerschaltung (2), die in Ansprache auf einen Deaktivierungsbefehl (DBS) ein die Deaktivierungstransistoren (T2) leitend machendes Deaktivierungs-Steuersignal (DSS) erzeugt und zwei alternativ einschaltbare Stromzweige aufweist,
- deren erster (T6) nur in seinem eingeschalteten Zustand die Steuerelektroden der Deaktivierungstransistoren (T2) mit einem diese Transistoren sperrenden ersten Potential (L_{L}) verbindet
- und deren zweiter (T7-T9) nur in seinem eingeschalteten Zustand die Steuerelektroden der Deaktivierungstransistoren (T2) mit einem diese Transistoren in Durchlassrichtung vorspannenden zweiten Potential (H_{L}-Vₜₕ) verbindet und Mittel enthält, welche die Amplitude und/oder der Flankensteilheit des Deaktivierungs-Steuersignals (DSS) reduzieren,
**dadurch gekennzeichnet,**
**dass** die Mittel im zweiten Stromzweig (T7-T9) zur Reduzierung der Amplitude und/oder der Flankensteilheit des Deaktivierungs-Steuersignals (DSS) derart ausgebildet sind, dass der über das Zuleitungssystem (DL) fließende Gesamtstrom einen vorgegebenn Wert nicht überschreitet,
und **dass** die Steuerschaltung (2) einen dritten Stromzweig (T4, T5) enthält, der alternativ zum ersten und zweiten Stromzweig einschaltbar ist und der nur in seinem eingeschalteten zustand die Steuerelektroden der Deaktivierungstransistoren (T2) mit einem diese Transistoren in die Sättigung treibenden dritten Potential (H) verbindet.

2. Schaltungsanordnung nach Anspruch 1, **dadurch gekennzeichnet, dass** die Mittel zur Reduzierung der Amplitude des Deaktivierungs-Steuersignals (DSS) aus einer Bemessung des zweiten Potentials (H_{L}-Vₜₕ) auf einen Wert bestehen, der die Deaktivierungstransistoren (T2) in einen begrenzt leitfähigen Zustand vorspannt.

3. Schaltungsanordnung nach Anspruch 2, **dadurch gekennzeichnet, dass** zur Bemessung des zweiten Potentials im zweiten Stromzweig (T7-T9) eine Diode oder ein als Diode verschalteter Transistor (T9) eingefügt ist, deren Einsatzspannung (Vₜₕ) sich im eingeschalteten Zustand dieses Zweiges subtrahiert vom Potential (H_{L}) einer an das Ende des Zweiges angeschlossenen Potentialquelle (H_{L}).

4. Schaltungsanordnung nach einem der Ansprüche 1 bis 3, **dadurch gekennzeichnet, dass** die Mittel zur Reduzierung der Flankensteilheit des Deaktivierungs-Steuersignals (DSS) aus mindestens einem in den zweiten Stromkreis eingefügten Element (T7, T8) merklichen ohmschen Widerstandes bestehen.

5. Schaltungsanordnung nach Anspruch 4, **dadurch gekennzeichnet, dass** das oder die Elemente ohmschen Widerstandes jeweils die Hauptstromstrecke eines Transistors (T7, T8) ist/sind, der zur Einschaltung des zweiten Stromkreises (T7-T9) aufgesteuert wird.

6. Schaltungsanordnung nach einem der Ansprüche 1 bis 5, **dadurch gekennzeichnet, dass** die Steuerschaltung (2) einen Eingang (EM) zum Anlegen eines Modus-Einstellsignals (MES) und'einen Eingang (ED) zum Anlegen eines binären Befehlssignals (DBS) hat und eine Verknüpfungseinrichtung (10-40) aufweist, die
- nur den ersten Stromzweig (T6) immer dann und nur dann eingeschaltet hält, wenn das Befehlssignal (DBS) einen ersten Binärwert ("1") hat,
- nur den zweiten Stromzweig (T7-T9) immer dann und nur dann einschaltet, wenn das Befehlssignal (DBS) den zweiten Binärwert ("0") hat und das Modus-Einstellsignal den anderen ("1") als den bestimmten Binärwert hat.
- den dritten Stromzweig (T5, T6) immer dann und nur dann eingeschaltet hält, wenn das Befehlssignal (DBS) einen zweiten Binärwert ("0") hat und das Modus-Einstellsignal einen bestimmten Binärwert ("0")hat.

## Claims

1. Circuit arrangement for deactivating word lines (WL) in a memory matrix (1), each of which has an associated deactivation transistor (T2) for connecting the relevant word line to a common supply line system (DL) carrying the deactivation potential for the word lines,
having a control circuit (2) which, in response to a deactivation command (DBS), produces a deactivation control signal (DSS) turning on the deactivation transistors (T2), and has two current paths which can be switched on as alternatives,
- the first (T6) of which, only when it is on, connects the control electrodes of the deactivation transistors (T2) to a first potential (L_{L}), which turns off these transistors,
- and the second (T7-T9) of which, only when it is on, connects the control electrodes of the deactivation transistors (T2) to a second potential (H_{L}-Vₜₕ), which biases these transistors in the forward direction, and contains means which reduce the amplitude and/or the edge gradient of the deactivation control signal (DSS),
**characterized**
**in that** the means in the second current path (T7-T9) for reducing the amplitude and/or the edge gradient of the deactivation control signal (DSS) are in a form such that the total current flowing through the supply line system (DL) does not exceed a prescribed value,
and **in that** the control circuit (2) contains a third current path (T4, T5) which can be turned on as an alternative to the first and second current paths and which, only when it is on, connects the control electrodes of the deactivation transistors (T2) to a third potential (H), which drives these transistors to saturation.

2. Circuit arrangement according to Claim 1, **characterized in that** the means for reducing the amplitude of the deactivation control signal (DSS) involve proportioning the second potential (H_{L}-Vₜₕ) to a value which biases the deactivation transistors (T2) in a state with limited conductivity.

3. Circuit arrangement according to Claim 2, **characterized in that**, for proportioning the second potential, the second current path (T7-T9) has a diode or a transistor (T9) wired up as a diode inserted in it whose threshold voltage (Vₜₕ) subtracts itself, when this path is on, from the potential (H_{L}) of a potential source (H_{L}) connected to the end of the path.

4. Circuit arrangement according to one of Claims 1 to 3, **characterized in that** the means for reducing the edge gradient of the deactivation control signal (DSS) comprise at least one element (T7, T8), inserted into the second circuit, of perceptible nonreactive resistance.

5. Circuit arrangement according to Claim 4, **characterized in that** the element(s) with nonreactive resistance is/are in each case the primary current path of a transistor (T7, T8) which is turned on in order to switch on the second circuit (T7-T9).

6. Circuit arrangement according to one of Claims 1 to 5, **characterized in that** the control circuit (2) has an input (EM) for applying a mode setting signal (MES) and an input (ED) for applying a binary command signal (DBS) and has a logic combination device (10-40) which
- keeps only the first current path (T6) switched on whenever and only when the command signal (DBS) has a first binary value ("1"),
- switches on only the second current path (T7-T9) whenever and only when the command signal (DBS) has the second binary value ("0") and the mode setting signal has the binary value ("1") other than the particular binary value,
- keeps the third current path (T5, T6) switched on whenever and only when the command signal (DBS) has a second binary value ("0") and the mode setting signal has a particular binary value ("0").

## Revendications

1. Circuit de désactivation de lignes de mot (WL) d'une matrice de mémoire (1) à chacune desquelles est associé un transistor de désactivation (T2) pour la liaison de la ligne de mot considérée avec un système d'amenée (DL) commun conduisant le potentiel de désactivation pour les lignes de mot,
avec un circuit de commande (2) qui produit en réponse à une instruction de désactivation (DBS) un signal de commande de désactivation (DSS) rendant conducteurs les transistors de désactivation (T2) et qui comporte deux branches de courant pouvant être mises en circuit en alternance,
- dont la première (T6) ne relie que dans son état en circuit les électrodes de commande des transistors de désactivation (T2) à un premier potentiel (L_{L}) bloquant ces transistors
- et dont la deuxième (T7 à T9) ne relie que dans son état en circuit les électrodes de commande des transistors de désactivation (T2) à un deuxième potentiel (H_{L} - Vₜₕ) polarisant ces transistors en sens passant et contient des moyens qui réduisent l'amplitude et/ou la pente du signal de commande de désactivation (DSS),
**caractérisé en ce que**
les moyens dans la deuxième branche de courant (T7 à T9) destinés à la réduction de l'amplitude et/ou de la pente du signal de commande de désactivation (DSS) sont conçus de telle sorte que le courant total passant par le système d'amenée (DL) ne dépasse pas une valeur prédéterminée
et le circuit de commande (2) contient une troisième branche de courant (T4, T5) qui peut être mise en circuit en alternance à la première et la deuxième branche de courant et qui ne relie que dans son état en circuit les électrodes de commande des transistors de désactivation (T2) à un troisième potentiel (H) amenant ces transistors à la saturation.

2. Circuit selon la revendication 1, **caractérisé en ce que** les moyens destinés à la réduction de l'amplitude du signal de commande de désactivation (DSS) consistent en un dimensionnement du deuxième potentiel (H_{L} - Vₜₕ) à une valeur qui polarise les transistors de désactivation (T2) dans un état de conduction limitée.

3. Circuit selon la revendication 2, **caractérisé en ce que**, pour le dimensionnement du deuxième potentiel, il est inséré dans la deuxième branche de courant (T7 à T9) une diode ou un transistor (T9) branché comme diode dont la tension de blocage (Vₜₕ) se soustrait, lorsque cette branche est en circuit, du potentiel (H_{L}) d'une source de potentiel (H_{L}) raccordée à l'extrémité de la branche.

4. Circuit selon l'une des revendications 1 à 3, **caractérisé en ce que** les moyens pour la réduction de la pente du signal de commande de désactivation (DSS) consistent en au moins un élément (T7, T8) inséré dans la deuxième branche de courant et ayant une résistance ohmique notable.

5. Circuit selon la revendication 4, **caractérisé en ce que** le ou les éléments à résistance ohmique est / sont à chaque fois la voie de courant principal d'un transistor (T7, T8) qui est commandé à l'état conducteur pour la mise en circuit de la deuxième branche de courant (T7 à T9).

6. Circuit selon l'une des revendications 1 à 5, **caractérisé en ce que** le circuit de commande (2) a une entrée (EM) pour l'application d'un signal de réglage de mode (MES) et une entrée (ED) pour l'application d'un signal d'instruction binaire (DBS) et comporte un dispositif de combinaison (10 à 40), qui
- maintient en circuit seulement la première branche de courant (T6) si et seulement si le signal d'instruction (DBS) a une première valeur binaire ("1"),
- maintient en circuit seulement la deuxième branche de courant (T7 à T9) si et seulement si le signal d'instruction (DBS) a la deuxième valeur binaire ("0") et le signal de réglage de mode a la valeur binaire ("1") différente de la valeur binaire déterminée,
- maintient en circuit seulement la troisième branche de courant (T5, T6) si et seulement si le signal d'instruction (DES) a une deuxième valeur binaire ("0") et le signal de réglage de mode a une valeur binaire déterminée ("0").
